# EUROPEAN PATENT APPLICATION

(11) **EP 4 160 693 A1**
(43) Date of publication of application: **05.04.2023**
(21) Application number: 21200017.8
(22) Date of filing: 29.09.2021
(51) Int. Cl.: H01L 29/06, H01L 29/40, H01L 29/78, H01L 29/66, H01L 21/336

(54) **TRANSISTOR DEVICE A METHOD FOR PRODUCING A TRANSISTOR DEVICE**

(71) Applicant: Infineon Technologies Austria AG, 9500 Villach (AT)
(72) Inventor: HENSON, Timothy, Mount Shasta, 96067 (US); GUO, Lina, Laguna Niguel, 92677 (US)
(74) Representative: JENSEN & SON

(57) **Abstract**

According to an embodiment, a transistor device comprises a semiconductor body comprising a first surface, a second surface opposing the first surface and side faces, an active area and an edge termination region that laterally surrounds the active area a drain region of a first conductivity type at the second surface, a drift region of the first conductivity type on the drain region and a body region of a second conductivity type that opposes the first conductivity type on the drift region. In the active area a source region of the first conductivity type is arranged on the body region. The body region has a doping concentration that is higher in the active area than in the edge termination region.

## Description

### BACKGROUND

Transistor devices used in power electronic applications are often fabricated with silicon (Si) semiconductor materials. Common transistor devices for power applications include Si CooIMOS^{®}, Si Power MOSFETs and Si Insulated Gate Bipolar Transistors (IGBTs).

A transistor device typically includes an active cell field including a plurality of transistor cells, each having a transistor structure. Typically, the active cell field of the transistor device is laterally surrounded by an edge termination structure which serves to avoid breakdown of the semiconductor device due to edge effects and to improve the performance of the device.

A transistor device for power applications may be based on the charge compensation principle, in particular have a superjunction structure for charge compensation. A superjunction device, which is often also referred to as a compensation device, includes a drift region with a plurality of regions of a first doping type (conductivity type) and a plurality of regions of a second doping type (conductivity type) complementary or opposite to the first doping type. Typically, the oppositely doped first and second regions each have the form of a vertical column which extends perpendicularly to the major surfaces of the device. When a blocking voltage is applied to the superjunction device, a lateral electric field rises and clears out the mobile charge carriers along the vertical pn junctions between the first and second regions. A space charge zones begins to expand perpendicularly to the direction of a load current flow in the on-state. The mobile charge carriers are completely forced out of the superjunction structure at a comparatively low blocking voltage. When the blocking voltage is further increased, the depleted superjunction structure acts as a quasi-intrinsic layer and the vertical electric field rises.

The breakdown voltage is decoupled from the dopant concentrations in the superjunction structure such that the dopant concentration in the superjunction structure can be comparatively high. Therefore, superjunction devices typically combine very low on-state resistance with high blocking capability. The efficiency of the superjunction structure in terms of blocking capability and semiconductor volume is better the better the dopant atoms in the oppositely doped regions of the superjunction structure are balanced and compensate each other.

US 2020/0365719 A1 discloses an example of a superjunction transistor device with an active region and an edge termination structure region which has a voltage with standing structure that surrounds a periphery of the active region.

Further improvements to the termination blocking voltage are desirable to improve the ruggedness of such transistor devices.

### SUMMARY

According to the invention, a transistor device is provided that comprises a semiconductor body comprising a first surface, a second surface opposing the first surface and side faces. The semiconductor body further comprises an active area and an edge termination region that laterally surrounds the active area; a drain region of a first conductivity type at the second surface, a drift region of the first conductivity type positioned on the drain region and a body region of a second conductivity type that opposes the first conductivity type, the body region being positioned on the drift region. In the active area, a source region of the first conductivity type is arranged on the body region. The body region has a doping concentration that is higher in the active area than in the edge termination region.

As used herein, a doping concentration that is higher in the active area than in the edge termination region means that the difference is at least 10% and, in some embodiments at least 20% or even greater than 50% or 100%. This difference in the doping concentration of the body region in the active area and in the edge termination region is therefore greater than fluctuations in the doping concentration arranging arising from processing effects, which are typically in the range of 1% to 3%. The body region has a doping concentration in the active area D_{active} that is at least 10% greater and, in some embodiments at least 20% or even at least 50% or 100% greater than the doping concentration D_{edge} in the edge termination region, i.e D_{active} ≥ 1.1D_{edge}, or D_{active} ≥ 1.2D_{edge}, or D_{active} ≥ 1.5D_{edge}, or D_{active} ≥ 2D_{edge}.

The active area is distinguishable from the edge termination region in that the edge termination region is free of the source region, i.e. the source region is located exclusively in the active area. In some embodiments, In the active area, a source region of the first conductivity type is arranged on the body region and extends to the first surface and in the edge termination region the body region extends to the first surface.

In some embodiments, the body region extends to the side faces of the semiconductor body. In these embodiments, the body region extends from one side face to the opposing side face.

In some embodiments, a pn junction formed between the drift region and the body region is positioned in the semiconductor body at a greater depth from the first surface in the active area than in the edge termination region.

As used herein, a greater depth means a difference of at least 10%. If the pn junction formed between the drift region and the body region in the active area is positioned in the semiconductor body at a depth X₁ from the first surface and the pn junction formed between the drift region and the body region in the edge termination region is positioned in the semiconductor body at a depth X₂ from the first surface, then X₁ ≥ 1.1X₂.

In some embodiments, the depth of pn junction formed between the drift region and the body region in the edge termination region is substantially uniform in a lateral direction from the active area to the side face of the semiconductor body.

In some embodiments, the depth of pn junction formed between the drift region and the body region in the edge termination region is substantially uniform throughout the edge termination region.

In some embodiments, a plurality of gate electrodes is provided in the active area. Each gate electrode is positioned in a gate trench that extends into the semiconductor body. Each transistor cell includes a gate electrode.

In some embodiments, the gate trench extends into the semiconductor body from the first surface. The gate electrode may be electrically insulated from the semiconductor body by a gate dielectric that is positioned on and lines side walls and a base of the gate trench.

In some embodiments, the transistor device further comprises a superjunction structure comprising a plurality of columns of the second conductivity type that extend substantially perpendicularly to the first surface and that are positioned in the drift region in the active area and in the edge termination region.

In some embodiments a contact to one, some or all of the individual ones of the columns of the second conductivity type is provided. In some embodiments, each contact extends through the body region to the column of the second conductivity type. The contacts for each column of the second conductivity type are laterally spaced part from one another. The contact comprises a material that is different from the material semiconductor body. The contact may comprise a trench in the semiconductor body that comprises an electrically conductive material and/or a dielectric material.

In some embodiments, the contact to the individual ones of the columns of the second conductivity type positioned in the active area is electrically conductive. Each contact may be provided by a trench in the semiconductor body that comprises an electrically conductive material. The contacts for each column of the second conductivity type are laterally spaced part from one another. The contacts may be electrically connected together by an electrically conductive layer arranged on the first surface.

In some embodiments, the contact to one or more of the individual ones of the columns of the second conductivity type positioned in the edge termination region is electrically conductive. If two or more electrically conductive contacts for the columns of the second conductivity type in the edge termination region are present, these electrically conductive contacts are laterally spaced part from one another. Each contact may be provided by a trench in the semiconductor body that comprises an electrically conductive material. These contacts in the edge termination region may be electrically connected together by an electrically conductive layer arranged on the first surface. These contacts in the edge termination region may also be electrically connected to the contacts to the columns of the second conductivity type arranged in the active area by a common electrically conductive layer arranged on the first surface.

In some embodiments, the contact to one or more of the individual ones of the columns of the second conductivity type positioned in the edge termination region is electrically insulating. If two or more electrically insulating contacts for the columns of the second conductivity type in the edge termination region are present, these electrically insulating contacts are laterally spaced part from one another. These electrically insulating contacts in the edge termination region may be provided by a trench in the semiconductor body that comprises a dielectric material.

In some embodiments, a combination of electrically conductive and electrically insulating contacts is provided in the edge termination region. In some embodiments, the contact to one or more of the individual ones of the columns of the second conductivity type positioned in the edge termination region is electrically conductive and the contact to a further one or more of the individual ones of the columns of the second conductivity type positioned in the edge termination region is electrically insulating, wherein the electrically insulating contact is positioned outboard, i.e. peripheral to, the electrically conductive contact.

In some embodiments, the edge termination region comprises a transition region, an inner edge termination region and an outer edge termination region, wherein the columns of the second conductivity type are arranged in the transition region and in the inner edge termination region. In some embodiments, the outer edge termination region is free of columns of the second conductivity type.

In some embodiments, in the active region the columns of the second conductivity type are electrically connected to source potential, in the transition region one or more of the columns of the second conductivity type are electrically connected to source potential and in the inner termination region, one or more of the columns of the second conductivity type are electrically floating.

In some embodiments, in the active region and in the transition region, a first contact through the body region for each of the columns of the second conductivity type is provided. The first contact comprises an electrically conductive material. In the inner termination region, a second contact through the body region for each of the columns of the second conductivity type is provided. The second contact comprises an insulating material.

In some embodiments, in the active region the first contact also extends though the source region and the body region to the columns of the second conductivity type. The first contact comprises an electrically conductive material.

In some embodiments, the edge termination region further comprises one or more trenches, one trench being arranged laterally between individual ones of the columns of the second conductivity type. The trenches are arranged in the transition region and in the inner edge termination region as columns of the second conductivity type are arranged in the transition region and in the inner edge termination region.

In some embodiments, the trenches each comprise conductive material that is electrically insulated from the semiconductor body. The conductive material may be electrically insulated from the semiconductor body by insulating material that lines the trench.

In some embodiments, the transistor device further comprising at least one edge trench arranged in the outer edge termination region. The at least one edge trench laterally surrounds the active area. The at least one edge trench may laterally and continuously surround the active area. The at least one edge trench is positioned laterally outside of the columns of the second conductivity type.

In an embodiment, a method of fabricating a transistor device is provided that comprises providing a semiconductor body of a first conductivity type comprising a first surface, a second surface opposing the first surface and side faces, a drain region of the first conductivity type at the second surface and a drift region of the first conductivity type on the drain region, implanting dopants of a second conductivity type into the first surface, the second conductivity type opposing the first conductivity type and forming a body region on the drift region, the body region extending between the side faces of the semiconductor body, locally implanting dopants of the first conductivity type into a predefined area of the first surface to form a source region on the body region, and locally implanting dopants of the second conductivity type into the first surface into the predefined area such that the body region comprises a higher concentration of dopants of the second conductivity type in the predefined area than laterally outside of the predefined area.

In some embodiments, the locally implanting dopants of the first conductivity type into a predefined area comprises applying a mask to the first surface, the mask having an opening that defines an active area of the transistor device, the peripheral region of the first surface being covered by the mask and forming an edge termination region of the transistor device. Dopants to form the first conductivity type in the semiconductor body are implanted though the opening in the mask into the first surface to form the source region on the body region.

In some embodiments, the locally implanting dopants of the second conductivity type into the first surface into the predefined area comprises implanting dopants to form the second conductivity type in the semiconductor body through the opening in the mask into the first surface.

In some embodiments, the semiconductor body further comprises a superjunction structure comprising a plurality of columns of the second conductivity type positioned in the drift region and extending substantially perpendicularly to the first surface, and a plurality of gate trenches, one of the gate trenches being arranged laterally between individual ones of the columns of the second conductivity type.

In some embodiments, each gate trench comprises a gate electrode that is electrically insulated from the semiconductor body by a gate dielectric that lines side walls of the gate trench.

Those skilled in the art will recognize additional features and advantages upon reading the following detailed description, and upon viewing the accompanying drawings.

### BRIEF DESCRIPTION

The elements of the drawings are not necessarily to scale relative to each other. Like reference numerals designate corresponding similar parts. The features of the various illustrated embodiments can be combined unless they exclude each other. Exemplary embodiments are depicted in the drawings and are detailed in the description which follows.
Figure 1A illustrates a plan view of a transistor device according to an embodiment.
Figure 1B illustrates a cross-sectional view of a portion of the transistor device of figure 1A.
Figure 1C illustrates an enlarged view of a portion of the transistor device of figure 1B.
Figure 2 illustrates a cross-sectional view of a transistor device including contact structures according to an embodiment.
Figure 3 illustrates a cross-sectional view of a transistor device including contact structures according to a further embodiment.
Figure 4 which includes figures 4A to 4D illustrates a method of fabricating a transistor device.

### DETAILED DESCRIPTION

In the following detailed description, reference is made to the accompanying drawings, which form a part hereof, and in which is shown by way of illustration specific embodiments in which the invention may be practiced. In this regard, directional terminology, such as "top", "bottom", "front", "back", "leading", "trailing", etc., is used with reference to the orientation of the figure(s) being described. Because components of the embodiments can be positioned in a number of different orientations, the directional terminology is used for purposes of illustration and is in no way limiting. It is to be understood that other embodiments may be utilized and structural or logical changes may be made without departing from the scope of the present invention. The following detailed description, thereof, is not to be taken in a limiting sense, and the scope of the present invention is defined by the appended claims.

A number of exemplary embodiments will be explained below. In this case, identical structural features are identified by identical or similar reference symbols in the figures. In the context of the present description, "lateral" or "lateral direction" should be understood to mean a direction or extent that runs generally parallel to the lateral extent of a semiconductor material or semiconductor carrier. The lateral direction thus extends generally parallel to these surfaces or sides. In contrast thereto, the term "vertical" or "vertical direction" is understood to mean a direction that runs generally perpendicular to these surfaces or sides and thus to the lateral direction. The vertical direction therefore runs in the thickness direction of the semiconductor material or semiconductor carrier.

As employed in this specification, when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present.

As employed in this specification, when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

As used herein, various device types and/or doped semiconductor regions may be identified as being of n type or p type, but this is merely for convenience of description and not intended to be limiting, and such identification may be replaced by the more general description of being of a "first conductivity type" or a "second, opposite conductivity type" where the first type may be either n or p type and the second type then is either p or n type.

The Figures illustrate relative doping concentrations by indicating "-" or "+" next to the doping type "n" or "p". For example, "n⁻" means a doping concentration which is lower than the doping concentration of an "n"-doping region while an "n⁺"-doping region has a higher doping concentration than an "n"-doping region. Doping regions of the same relative doping concentration do not necessarily have the same absolute doping concentration. For example, two different "n"-doping regions may have the same or different absolute doping concentrations.

A transistor device is optimized for switching applications and typically has a voltage rating indicating the voltage at which the transistor device may be safely operated. When the transistor device is off, it is capable of blocking a certain voltage, such as 100V, 120V or 150V, known as the blocking voltage or BVDSS for a particular drain source current (I_{DS}). When the transistor device is on, it has a sufficiently low on-resistance (RON) for the application in which it is used, i.e. it experiences sufficiently low conduction loss when a substantial current passes through the device.

Some types of transistor device, including superjunction transistor devices, include a cell field comprising a plurality of substantially identical transistor cells, each having a transistor structure. The cells are electrically connected to form a single transistor device for switching. The cell field provides the active area of the transistor device within the semiconductor die in which the transistor device is formed. The transistor device includes an edge termination region that laterally surrounds the cell field and that has an edge termination structure that serves to reduce the peak lateral electric field between the cell field and the side faces of the transistor device, i.e. the side faces of the semiconductor die, to avoid breakdown of the semiconductor device due to edge effects and to improve the performance of the device.

The disclosure provides edge termination structures that are suitable for a superjunction or charge balance transistor device having implanted columns of the opposing conductivity type to the conductivity type of the drift region are provided. In some embodiments, a plurality of trenches is formed in the semiconductor substrate and dopants implanted into the base of the trenches to form the columns of a conductivity type that opposes the conductivity type of the semiconductor substrate, for example p-type columns in a n-type semiconductor substrate. Utilizing multiple trenches to implement the superjunction structure can assist in effectively reducing the total area taken by termination and thus further shrink total die size area. The device has not only a low on-resistance, but also high ruggedness. An improvement in AC performance can also be achieved.

According to some embodiments of the present invention, a separate termination body region and a separate channel or active area body region is provided in order to improve the termination blocking voltage and at same time to provide an active cell Vth (threshold voltage) at the desired value. The body region in the active area has a higher doping concentration to achieve the desired threshold voltage. This is achieved without lowering the blocking voltage, since the blocking voltage in the termination region is separately optimized by using a different (lower) doping concentration for the body region in the termination region. This also allows the design of the termination structure to be optimized independently to improve the blocking voltage of the device.

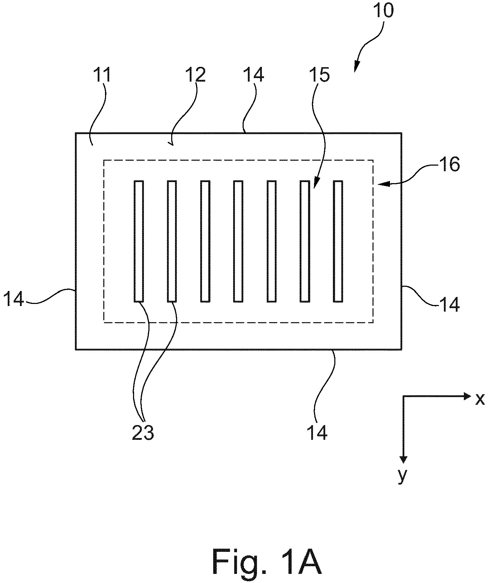

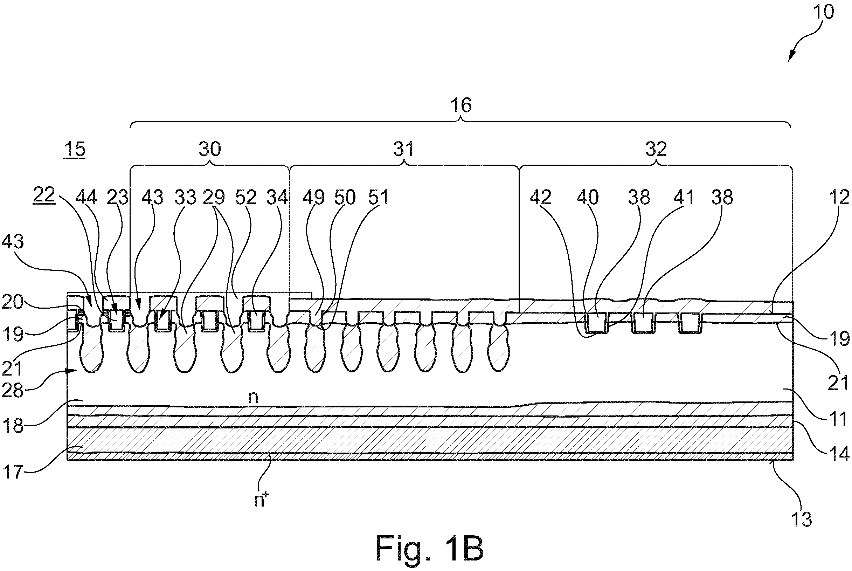

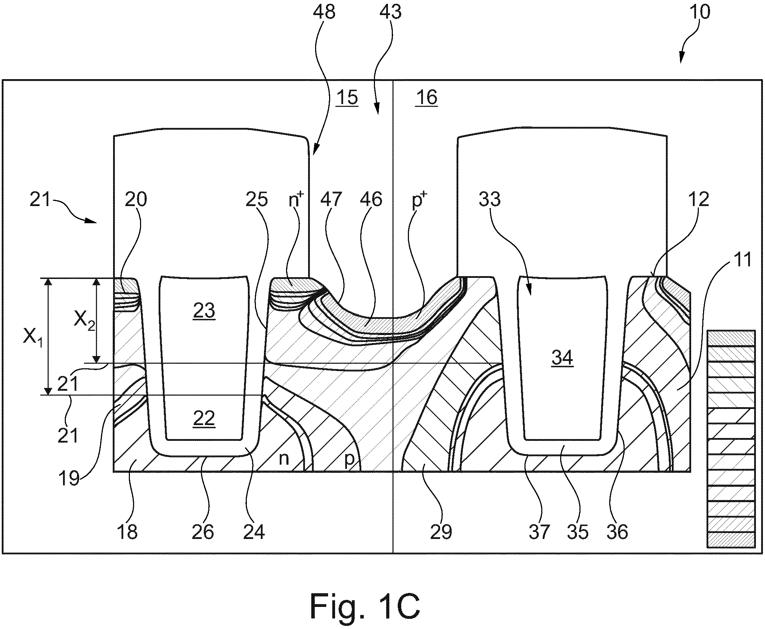

Figure 1 illustrates a transistor device 10 according to an embodiment, whereby figure 1A illustrates a top view of the transistor device 10, figure 1B a cross-sectional view of a portion of the transistor device 10 and figure 1C an enlarged view of a portion of the transistor device 10 illustrated in figure 1B

The transistor device 10 comprises a semiconductor substrate or semiconductor body 11 that has a first surface 12, second surface 13 that opposes the first surface and side faces 14. The side faces 14 extend between the first surface 12 and the second surface 13. The semiconductor body typically has a cuboid shape in which the first and second surfaces 12, 13 are each substantially planar and extend substantially parallel to one another and four side faces extend substantially perpendicularly to the first surface 12 and second surface 13. Using the Cartesian coordinate system, the first surface 12 may lie in the x-y plane and the side faces extend in the z direction.

The semiconductor body 11 may comprise silicon and may include a monocrystalline silicon epitaxial layer deposited on a substrate such as a single crystal silicon substrate. The first surface 12 can be referred to as the top surface and the second surface 13 as the rear surface. The transistor device 10 may be a Field Effect Transistor device, such as a MOSFET device having a superjunction compensation structure.

The semiconductor device comprises an active area 15 and an edge termination region 16 that laterally surrounds the active area 15. The active area 15 includes a plurality of transistor cells, each transistor cell having a transistor structure. The edge termination region 16 laterally surrounds the active area 15. The edge termination region 16 is positioned at the periphery of the semiconductor body 11 and encircles the active area 15 on all sides. The active area 15 is used for switching and the edge termination region 16 comprises an edge termination structure for avoiding break-down of the transistor device 10 at or near the first surface 12 and for increasing the breakdown voltage of the transistor device 10. The edge termination structure may, for example, lower the field intensity junction by spreading the electric field lines across the edge termination region 16.

The semiconductor body 11 comprises a drain region 17 of a first conductivity type at the second surface 13, a drift region 18 of the first conductivity type arranged on the drain region 17 and a body region 19 of a second conductivity type arranged on the drift region 18. The second conductivity type opposes the first conductivity type. For example, the first conductivity type may be n-type and the second conductivity type may be p type. Alternatively, the first conductivity type may be p type in which case the second conductivity type is n type. The drain region 17, drift region 18 and body region 19 extend over the entire area of the semiconductor body 11. The drain region 17 is typically more highly doped than the drift region 18.

In the active area 15 of the semiconductor body 11, a source region 20 of the first conductivity type is arranged on the body region 19. The source region 20 is typically more highly doped than the drift region 18. The edge termination region 16 does not, however, include a source region 20. In contrast to the source region 20 which is positioned exclusively in the active area 15, the body region 19 is positioned in both the active area 15 and in the edge termination region 16. In some embodiments, the body region 19 extends throughout both the active area 15 and the edge termination area region 16 and extends to all of the side faces 14 of the semiconductor body 11.

The body region 19 has a doping concentration that is higher in the active area 15 than in the edge termination region 16. As used herein, a doping concentration that is higher in the active area 15 than in the edge termination region 16 means that the difference is at least 10% and, in some embodiments at least 20% or even greater than 50% or 100%, i.e. the doping concentration D_{active} of the body region 19 in the active area 15 under the source region 20 is at least 10% or 20% greater or 50% greater of 100% greater than the doping concentration D_{edge} of the body region 19 in the edge termination region 16.. This difference in the doping concentration of the body region 19 in the active area 15 and edge termination region 16 is therefore greater than fluctuations in the doping concentration arranging arising from processing effects, which are typically in the range of 1% to 3%.

The body region 19, therefore, has a selectively locally increased doping concentration in the active area 15. This discrete area of the body region 19 which has the increased doping concentration may have a lateral extent which corresponds to the lateral extent of the active area 15 and to the lateral extent of the source region 20. Consequently, outside of the portion of the semiconductor body 11 which includes the source region 20, the body region 19 has a lower doping concentration compared to that portion of the body region 19 which is positioned under and that forms a pn junction with the source region 20.

The higher doping concentration of the body region 19 in the active area 15, compared to the doping concentration of the body region 19 positioned in the edge termination region 16 may be used to assist in increasing the threshold voltage or providing a desired threshold voltage. A corresponding increase in the doping concentration of the body region 19 in the edge termination region 16 would, however, lead to a decrease in the blocking voltage of the edge termination region and lead to a decrease in the blocking voltage of the transistor device. This effect is avoided in the transistor device 10, since the doping concentration of the body region 19 in the edge termination region 16 is lower compared to that used in the active area 15.

A pn junction 21 is formed between the body region 19 and the underlying drift region 18. In some embodiments, the pn junction 21 formed between the body region 19 and the drift region 18 at positions within the active area 15 is located in the semiconductor body 11 at a greater depth from the first surface 12 than the pn junction between the body region 19 and the drift region 19 at positions within the edge termination region 16.

Figure 1C illustrates a cross-sectional view of a portion of the transistor device 10 and in particular, an enlarged view of an active transistor cell 21 and illustrates a portion of the active area 15 and an adjoining portion of the edge termination area 16. The active area 15 includes a source region 20 arranged on the body region 19 which is arranged in turn on the drift region 18. In the edge termination region 16 the body region 19 is positioned on the drift region 18 and differs from the active area 15 in that no source region 20 is positioned at the first surface 12 on the body region 19. As can be seen in figure 1C, the pn junction 21 between the body region 19 and the drift region 18 within the active area 15 is positioned at a depth X1 from the first surface 12. The position of the pn junction 21 between the body region 19 and the drift region 18 located within the edge termination region 16 is positioned at a distance X2 from the first surface 12, whereby X2 is smaller than X1. The difference between X1 and X2 is again larger than that obtained by variations arising from manufacturing variations and is at least 10%.

Referring to figures 1B and 1C, the active area 15 further comprises a plurality of gate electrodes 22, whereby each gate electrode 22 is positioned in a gate trench 23. The gate trench 23 extends into the semiconductor body 11 from the first surface and has side walls 25 which are substantially perpendicular to the first surface 12 and a base 26. The gate trench 23 includes a gate electrode 22 which is electrically insulated from the semiconductor body 11 by a gate dielectric 24 which lines the side walls 25 and the base 26 of the gate trench 23. The gate trench 23 may have an elongate stripe-like form in plan view. Each transistor cell includes a gate trench 23 which extends through the source region 20 and body region 19. The base of 26 of the gate trench 23 is positioned at a greater depth from the first surface 12 than the depth X1 of the pn junction 21 between the drift region 18 and the body region 19.

Referring to figure 1B, the transistor device 10 further comprises a superjunction structure 28 which comprises a plurality of columns 29 of the second conductivity type that extend substantially perpendicular to the first surface 12. The columns 29 are positioned in the drift region 18 and are located in both the active area 15 and in the edge termination region 16. The columns 29 of the second conductivity type do not extend as far as the drain region 17 and are vertically spaced apart from the drain region 17 by a portion of the drift region 18. The upper end of the columns 29 of the second conductivity type may be arranged below and spaced apart from the body region 19 in both the active area 15 and in the edge termination region 16. The columns 29 form pn junctions with the drift region 18 which extend substantially perpendicular to the first surface 12. The columns 29 of the second conductivity type have a lateral pitch which may be the same in the active area 15 and in the edge termination region 16 or which may be different in the edge termination region 16 compared to the active area. In the active area 15, one of the gate trenches 23 is positioned between and laterally spaced apart from neighbouring ones of the columns 29.

In other embodiments, the upper end of the columns 29 may be arranged at about the pn junction between the body region 19 and the drift region 18 or above the pn junction between the body region 19 and the drift region 18. Since the body region 19 may extend deeper into the semiconductor body 11 in the active area 15 than in the edge termination region 16, the upper end of the columns 29 of the second conductivity type positioned in the active area 15 may be positioned within the body region 19 and above the pn junction between the body region 19 and the drift region 18 and the upper end of the columns 29 of the second conductivity type positioned in the edge termination region 16 may be positioned below and spaced apart from the body region 19 in the edge termination region 16.

The edge termination region 16 will now be described in more detail with reference to figure 1B. The edge termination region 16 comprises three concentric subregions, namely a transition region 30, an inner edge termination region 31 and an outer edge termination region 32. The transition region 30 laterally surrounds the active region 15, the inner edge termination region 31 laterally surrounds the transition region 30 and the outer edge termination region 32 laterally surrounds the edge termination region 31 and extends to the side faces 14 semiconductor body. The edge termination region 16 has a different structure in each of these subregions. However, the body region 19 extends through these subregions and may have a depth from the first surface 12 that is substantially the same throughout the transition region 30, the inner edge termination region 31 and outer edge termination region 32.

The transition region 30 includes a superjunction structure 28 and at least one column 29 of the second conductivity type which extend substantially perpendicularly to the first surface 12 and which are positioned in the drift region 18. The transition region 30 also comprises a plurality of trenches 33, one trench 33 being positioned laterally between individual ones of the columns 29 of the second conductivity type. The trenches 33 may have the same structure as the gate trenches 23 positioned in the active area 15 and may include a conductive portion 34 which is electrically insulated from the semiconductor body 11 by dielectric layer 35 which lines the sidewalls 36 and base 37 of the trench 33. The trenches 33 do not however contribute to the switching of the transistor device 10 since there is no source region positioned in the transition region 30.

Whilst in the embodiment illustrated in figure 1B, the trenches 33 in the transition region 30 have the same structure as the gate trenches 23 in the active area 15, in other embodiments, the structure of the trenches 33 and/or their width or depth may differ from the gate trenches. From a manufacturing point of view, it is, however, more convenient that the trenches 33 and the transition region 30 have the same structure as the gate trenches in the active area 15. In these embodiments, the trenches 33 may be formed at the same time as the gate trenches 23 with the gate electrodes 22.

The inner edge termination region 31 also comprises a superjunction structure 28 comprising at least one column 29 of the second conductivity type which extends substantially perpendicularly to the first surface 12 and which is positioned in the drift region 18. In the embodiment illustrated in figure 1B, the inner edge termination region 31 is distinguishable from the transition region 30 in that it does not include any trenches between the columns 29 of the second conductivity type.

The outer edge termination region 32 is distinguishable from the inner edge termination region 31 in that it does not include a superjunction structure and therefore, is free of columns of the second conductivity type. In some embodiments, the outer edge termination region 32 includes one or more edge trenches 38. The edge trenches 38 extend into the semiconductor body 11 from the first surface 12. In plan view, the one or more edge trenches 38 may laterally surround the active area 15 and also continuously and uninterruptedly encircle the active area 15. Since the outer edge termination region 32 is positioned laterally outside of the inner edge termination region 31, which in turn is positioned laterally outside of the transition region 30, the edge trenches 38 also laterally surround and continuously and uninterruptedly encircle the inner edge termination region 31 and the transition region 30. The edge trenches 38 may comprise a conductive material which is electrically insulated from the semiconductor body 11 by an insulating layer 40 which lines the sidewalls 41 and base of the trench 42. The edge trenches 38 may be fabricated at the same time as the gate trenches and the trenches 33 in the transition region 30. In other embodiments, the edge trenches 38 may have a different structure from the trenches 33 in the transition region 30 and the gate trenches. In some embodiments, the edge trenches 38 may be entirely filled with an insulating material.

In the transistor design illustrated in figures 1B and 1C, a first contact 43 is provided for each of the columns 29 of the second conductivity type which are positioned in the active area 15 and in the transition region 30. The first contacts 43 are, therefore, positioned laterally between and spaced apart from the gate trenches 23 in the active area 15. Each first contact 43 is positioned in an opening 48 formed in the semiconductor body 11 and extending into the semiconductor body 11 from the first surface 12. In the active area, the first contact 43 extends through the source region 29 and the body region 19 and has a base which is positioned in the column 29 of the second conductivity type at a depth from the first surface 12 which is greater than the depth of the pn junction 21 between the body region 19 and drift region 18.

In the edge termination region 16, the first contact 43 extends through the body region 19 and has a base which is positioned in the column 29 of the second conductivity type at a depth from the first surface 12 which is greater than the depth of the pn junction 21 between the body region 19 and drift region 18.

The first contacts 43 comprise an electrically conductive material. In the active area 15, each first contact 43 provides an electrically conductive connection to the source region 20, body region 19 and to the column 29 of the second conductivity type. In the edge termination region 16, each first contact 43 provides an electrically conductive connection to the body region 19 and to the column 29 of the second conductivity type. The first contacts 43 in the active rea 15 and in the edge termination region 16 are electrically connected to one another by an electrically conductive layer 52, typically metallic arranged on the first surface 12. The conductive layer 52 and the first contacts 43 are insulated from the gate electrodes 23 by a dielectric layer 44 arranged between the first surface 12, the gate electrodes 22 and the overlying conductive layer 52. The first contacts 43, therefore, also extend through the dielectric layer 44.

In some embodiments, a doped contact region 46 is provided in the semiconductor body 11 at the base 47 of the opening 48 for each first contact 43. The contact region 46 is more highly doped than the doping level of the body region 19 within the active area 15 and within the edge termination region 16.

The inner edge termination region 31 also comprises at least one column 29 of the second conductivity type. A second contact 49 is provided in the inner edge termination region 31 for each of the columns 29 of the second conductivity type. The second contact 49 is formed in an opening 50 which extends through the body region 19 and has a base 51 which is positioned in the column 29 of the second conductivity type. The base 51 of the second contact 49 may have a depth from the first surface 12 which is the same or less than the depth of the base 47 of the openings 48 for the first contacts 43 in the active region 15 and in the transition region 30. In contrast to the first contact 43, the second contact 49 comprises an electrically insulating material and does not provide an electrical contact to the columns 29 of the second conductivity type which are positioned within the inner edge termination region 31. The second contacts 49 may be referred to as dummy contacts. The columns 29 of the second conductivity type that are positioned in the inner edge termination region 31 are, therefore, electrically floating. In some embodiments, the openings 50 for forming the second contacts 49 may be filled with the insulating layer 44 which further extends onto and is positioned on the first surface 12 and which covers the gate electrodes 23. In some embodiments, the insulating layer 44 also covers the edge trenches 38 in the outer edge termination region 32.

The inner edge termination region 31 is distinguishable from the transition region 30 in that it the columns 29 of the second conductivity type positioned in the transition region 30 are connected to source whereas the columns 29 of the second conductivity type positioned in the inner edge termination region 31 are not connected to source as the second contacts 49 are electrically insulating.

The number of columns 29 positioned in the transition region 30 and in the inner edge termination region 31 may vary from that illustrated in figure 1B, but at least one column 29 is positioned in each of the transition region 29 and the inner edge termination region 31.

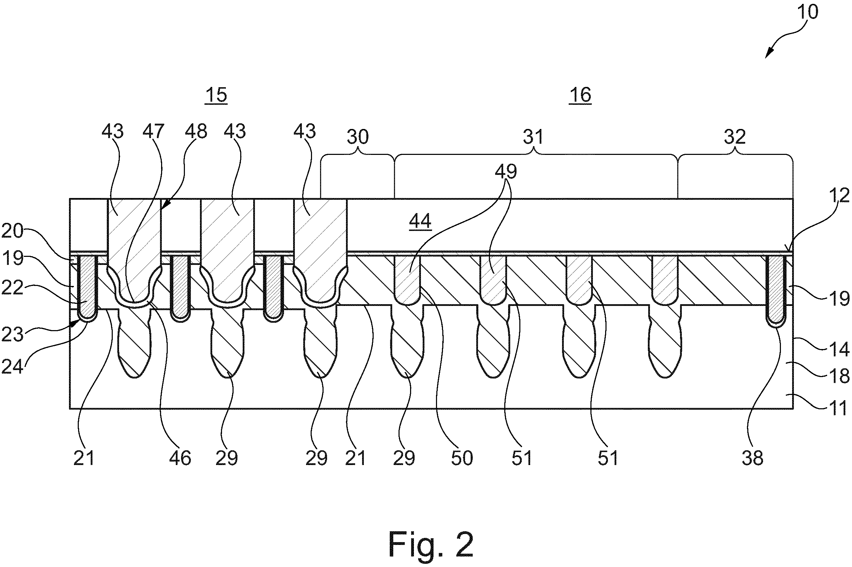

Figure 2 illustrates a cross-sectional view of a portion of a transistor device 10 in which the conductive material of the first contact 43 is illustrated. In this embodiment, the transistor device includes a single column 29 comprising the second conductivity type in the transition region 30 which is shared with the active region 15. The opening 50 for each of the second contacts 49 to the columns 29 of the conductivity type that are positioned in the inner edge termination region 31 is filled with insulating material 51. The insulating layer 44 that is positioned on the first surface 12 of the semiconductor body 11 is also positioned on this insulating material 51 in the opening 50 and, therefore, on the second contacts 49. The width and shape of the opening 50 for the second contact 49 differs from the openings through the dielectric layer 44, the source region 20 and body region 19 to the column 20 of the second conductivity type for the first contacts 43.

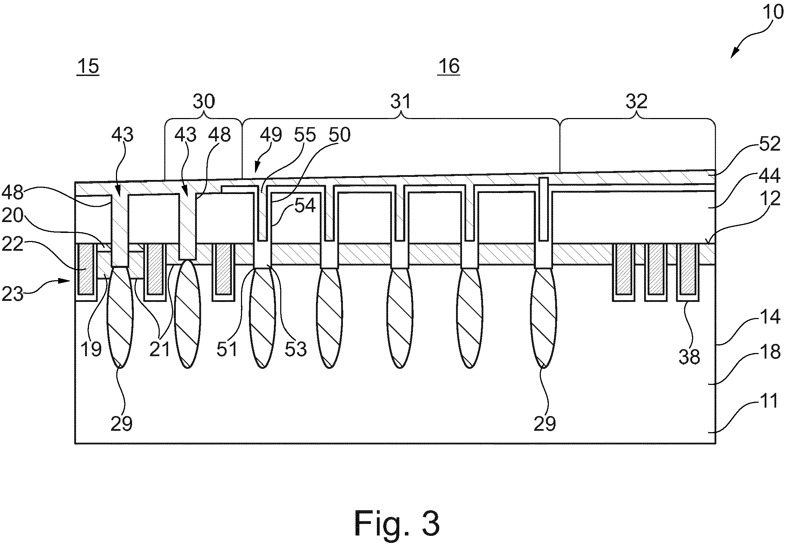

Figure 3 illustrates a cross-sectional view of a portion of a transistor device 10 according to another embodiment. In this embodiment, the second contact 49 comprises an insulating material 53 which lines the sidewalls 54 and base 51 of the opening 50 and further comprises conductive material 55 positioned in the opening in the gap between the layer of insulating material 53 lining the sidewalls 54 and base 51 of the second opening 50. The conductive material 55 may be formed at the same time as the conductive material is inserted into the openings for the first contacts 43 and may, therefore, be electrically connected to the source contact of the transistor device 10. Due to the insulating material 53 which lines the opening 50 for the second contact 49, this conductive material 55 and the second contact 49 is electrically insulated from the column 29 of the second conductivity type in the inner edge termination region 31. The columns 29 of the second conductivity type that are positioned in the inner edge termination region 31 are, therefore electrically floating.

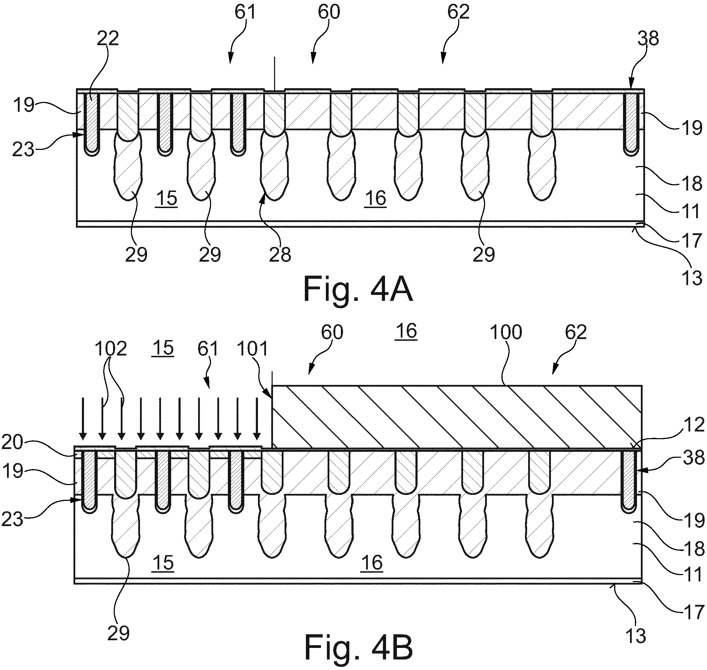

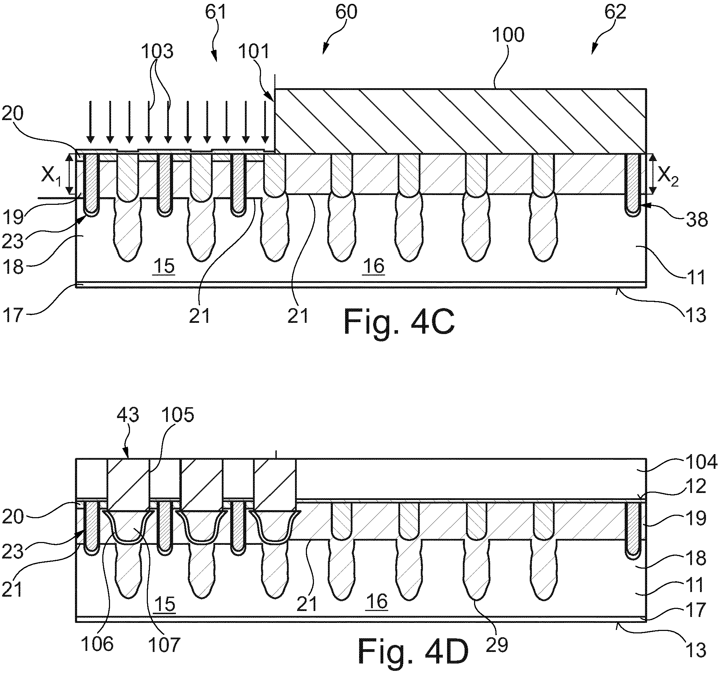

A method of manufacturing a transistor device will now be described with reference to figure 4, which includes figures 4A to 4D. Figure 4A illustrates a semiconductor body 11 of a comprising a first conductivity type that has a first surface 12 and a second surface 13 that opposes the first surface and side faces 14 which extend between the first surface 12 and the second surface 13. The semiconductor body 11 may be formed of silicon, such as monocrystalline silicon or an epitaxial silicon layer on a single crystal silicon substrate. A drain region 17 of the first conductivity type is positioned at or near the second surface 13. The semiconductor body 11 further comprises a drift region 18 of the first conductivity type positioned on the drain region 17. The drain region 17 is more highly doped than the drift region 18. In some embodiments, the drain region 17 is provided by a highly doped silicon substrate. In some embodiments, after completion of the processing of the first surface 12, the second surface 17 is subjected grinding and polishing to reduce the thickness of the substrate and decrease the thickness of the semiconductor body 11 to the desired final thickness.

The semiconductor body 11 of a single transistor device 10 is typically processed as one of a plurality of device positions 60 in a semiconductor wafer. The device positions are typically arranged in rows and columns and separated from one another by saw streets. All of the device positions 60 in the wafer are processed at substantially the same time. After a transistor device 10 is formed in each of the device positions, the wafer is singulated to create a plurality of discrete semiconductor bodies, also referred to as dies or chips, each including a transistor device 10.

Figure 4 illustrates a partial cross-sectional view of a single device position 60 and illustrates a portion 61, which is to form the active area 15 of the transistor device 10 used for switching, and a portion 62 which is to form an edge termination region 16 which laterally surrounds the active area 15 and which is positioned at the periphery of each of the device positions 60. A superjunction structure 28 has been fabricated which includes a plurality of columns 29 of second conductivity type, which opposes the first conductivity type which extend substantially perpendicularly to the first surface 12. The columns 29 of second conductivity type are positioned within the drift region 18 and which do not extend as far as the drain region 17. This creates a plurality of pn junctions between the columns 29 of the second conductivity type and the drift region 18 which extend substantially perpendicularly to the first surface 12. In the portion 61 of the device position which is for form the active area 15, typically the central area of the device position 60, a gate trench 23 is formed between neighbouring ones of the columns 29 of the second conductivity type. The gate trench 23 is lined with a dielectric material 24 forming the gate dielectric and a conductive gate electrode 22 is formed in the trench 23 on the dielectric material 24 to create a trench gate electrode 22. In this embodiment, the portion 62 of the device position 60 which is to from the edge termination region 16 does not include any trenches positioned between the columns 29 of the second conductivity type.

An edge trench 38 is provided at the periphery of the semiconductor body 11. In this embodiment, the edge trench 38 also includes conductive material 63 which is electrically insulated from the semiconductor body 11 by an insulating layer 64 which lines the sidewalls 65 and the base 66 of the trench. The edge trench 38 laterally continuously surrounds the columns 29 of the second conductivity type in the edge termination region 16 and in the active area 15. Dopants of a second conductivity type have been implanted into the semiconductor body into the first surface 12 so as to form a body region 19 of the second conductivity type in the semiconductor body 11 This body region 19 extends laterally throughout the device position 60 and therefore throughout the active area 15 and the edge termination region 16 to the side faces 14 of the semiconductor body. A pn junction 21 between the body region 19 and the drift region 18 is formed that has a depth X2 from the first surface 12.

Referring to be figure 4B, a mask 100 is applied to the first surface 12 which has an opening 101 which is positioned above the portion of the device position 60 which is to form the active area 15. Dopants of the first conductivity type are implanted through the first surface 12 into the semiconductor body 11 in the region exposed by the opening 101. The implantation of the dopants of the first conductivity type is indicated by the arrows 102. The dopants of the first conductivity type are locally implanted into a predefined area of the first surface 12 which is to form the active area 15 and form a source region 20 at the first surface 12 which is positioned on the body region 19. The depth of the source region 20 from the first surface 12 is less than the depth of the body region 19. The opening 101 in the mask 100 defines the predetermined area 61 of the device position 60 which is to form the active area 15 of the final transistor device 10.

Referring to figure 4C, as indicated schematically by the arrows 103, dopants of the second conductivity type are implanted into the first surface 12 in the predetermined region 61 of the device position 60 exposed by the opening 101 in the mask 100. The dopants of the second conductivity type are locally implanted into predefined area exposed by the opening 101 in the mask 100 so that the concentration of the dopants of the second conductivity type in the body region 19 in this predefined area 61 of the semiconductor body 11, which is to form the active area 15 of the transistor device, is greater than in the portion 62 of the body region 19 which is covered by the mask 100 and which is to form the edge termination region 16 of the transistor device. In some embodiments, the pn junction 21 formed between the body region 19 and the underlying drift region 18 is positioned at a greater depth X1 from the first surface 12 in the predefined region 61 of the semiconductor body 11 which has been to subjected to the second implantation with dopants of the second conductivity type compared to the depth of the pn junction 21 formed between the body region 19 and the drift region 18 in the regions located under the closed part of the mask 100 which will form the edge termination region 16 of the transistor device.

The doping concentration of the body region 19 before application of the mask 100 may be selected to be optimised for the edge termination region 16. The edge termination region 16 is then covered by the mask 100. The same mask 100 is used for implanting the source region 20 and carrying out the second implant of dopants of the second conductivity type in the active area 15. This is a simple way of controlling the area extent of the second implantation of the second dopants and confining these dopants to the active area 15. Thus the concentration of the dopants of the second conductivity type in the body region 19 in the active area 15 can be independently controlled from the concentration of dopants in the body region 19 in the edge termination region 16. The implanting conditions used for the second implantation of dopants of the second conductivity type into the active area 15 can be selected such that the total doping concentration provided by the two implantations provides the total desired doping concentration and threshold voltage in the active area 15. As an example, the implantation conditions used for the first implant of the body region 19 in both the active area 15 and in the edge termination region 16 may be 3e12 at 40kEV and for the second implant in the active area 15 only may be 5e12 at 40keV.

Referring to figure 4D, the method continues by forming a first electrically conductive contact 43 for individual ones of some of the columns 29 of the second conductivity type which are positioned in the active region 15 and some of the adjacent columns 29 of the second conductivity type which are to be positioned in the edge termination region 16, in particular in the transition region 30 of the edge termination region 16 that is positioned contiguously and laterally adjacent to the active area 15. The mask 100 is removed and an insulating or dielectric layer 104 applied to the first surface 12. The insulating layer 104 can be structured to provide one or more openings 105 above individual ones of the columns 29 of the second conductivity type on first surface 12 which are positioned in the active region 15 and one or more of the adjacent columns 29 of the second conductivity type which are to be positioned in the transition region 30 of the edge termination region 16. The semiconductor body 11 is etched through the openings 105 to produce in each case a trench 106 in the semiconductor body 11 which extends through the source region 20 and the body region 19 to the column 29 of the second conductivity type. Conductive material 107 is then inserted into the trenches 106 so as to produce a contact 43 to the source region 20, body region 19 and the columns 29 of the second conductivity type.

A transistor device 10 with a superjunction structure is provided that comprises a separate termination body region and a separate channel or active area body region having differing doping concentrations. The transistor device 10 has as improved termination blocking voltage and an active cell Vth (threshold voltage) at the desired value. The body region 19 in the active area 15 has a higher doping concentration that in the edge termination region 16 in order to achieve the desired threshold voltage. This is achieved without lowering the blocking voltage of the transistor device, since the blocking voltage in the termination region is separately optimized by using a different (lower) doping concentration for the body region in the termination region. This also allows the design of the termination structure to be optimized independently to improve the blocking voltage of the device.

Spatially relative terms such as "under", "below", "lower", "over", "upper" and the like are used for ease of description to explain the positioning of one element relative to a second element. These terms are intended to encompass different orientations of the device in addition to different orientations than those depicted in the figures. Further, terms such as "first", "second", and the like, are also used to describe various elements, regions, sections, etc. and are also not intended to be limiting. Like terms refer to like elements throughout the description.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise. It is to be understood that the features of the various embodiments described herein may be combined with each other, unless specifically noted otherwise.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A transistor device, comprising
a semiconductor body comprising:
a first surface, a second surface opposing the first surface and side faces;
an active area and an edge termination region that laterally surrounds the active area;
a drain region of a first conductivity type at the second surface, a drift region of the first conductivity type on the drain region, a body region of a second conductivity type that opposes the first conductivity type on the drift region,
wherein in the active area a source region of the first conductivity type is arranged on the body region,
wherein the body region has a doping concentration that is higher in the active area than in the edge termination region.

2. A transistor device according to claim 1, wherein the body region extends to the side faces of the semiconductor body.

3. A transistor device according to claim 1 or claim 2, wherein a pn junction formed between the drift region and the body region is positioned in the semiconductor body at a greater depth from the first surface in the active area than in the edge termination region.

4. A transistor device according to any one of claims 1 to 3, wherein in the active area a plurality of gate electrodes is provided, wherein each gate electrode is positioned in a gate trench that extends into the semiconductor body.

5. A transistor device according to any one of claims 1 to 4, further comprising a superjunction structure comprising a plurality of columns of the second conductivity type that extend substantially perpendicularly to the first surface and that are positioned in the drift region in the active area and in the edge termination region.

6. A transistor device according to claim 5, wherein the edge termination region comprises a transition region, an inner edge termination region and an outer edge termination region, wherein the columns of the second conductivity type are arranged in the transition region and in the inner edge termination region and the outer edge termination region is free of columns of the second conductivity type.

7. A transistor device according to claim 6, wherein in the active region the columns of the second conductivity type are electrically connected to source potential, in the transition region one or more of the columns of the second conductivity type are electrically connected to source potential and in the inner termination region, one or more of the columns of the second conductivity type are electrically floating.

8. A transistor device according to claim 6 or claim 7, wherein in the active region and in the transition region, a first contact through the body region for each of the columns of the second conductivity type is provided, wherein the first contact comprises an electrically conductive material, and in the inner termination region, a second contact through the body region for each of the columns of the second conductivity type is provided, wherein the second contact comprises an insulating material.

9. A transistor device according to any one of claims 5 to 8, wherein the edge termination region further comprises a plurality of trenches, one trench being arranged laterally between individual ones of the columns of the second conductivity type.

10. A transistor device according to claim 9, wherein the trenches each comprise conductive material that is electrically insulated from the semiconductor body.

11. A transistor device according to one of claims 5 to 10, further comprising at least one edge trench arranged in the outer edge termination region, wherein the at least one edge trench laterally surrounds the active area.

12. A method for fabricating a transistor device, the method comprising:
providing a semiconductor body of a first conductivity type comprising a first surface, a second surface opposing the first surface and side faces, a drain region of the first conductivity type at the second surface and a drift region of the first conductivity type on the drain region;
implanting dopants of a second conductivity type into the first surface, the second conductivity type opposing the first conductivity type and forming a body region on the drift region, the body region extending between the side faces of the semiconductor body;
locally implanting dopants of the first conductivity type into a predefined area of the first surface to form a source region on the body region;
locally implanting dopants of the second conductivity type into the first surface into the predefined area such that the body region comprises a higher concentration of dopants of the second conductivity type in the predefined area than laterally outside of the predefined area.

13. A method according to claim 12, wherein the locally implanting dopants of the first conductivity type into a predefined area comprises:
applying a mask to the first surface, the mask having an opening that defines an active area of the transistor device, the peripheral region of the first surface being covered by the mask and forming an edge termination region of the transistor device and
implanting the dopants of the first conductivity type though the opening into the first surface to form the source region on the body region.

14. A method according to claim 13, wherein the locally implanting dopants of the second conductivity type into the first surface into the predefined area comprises:
implanting dopants of the second conductivity type through the opening in the mask into the first surface.

15. A method according to any one of claims 12 to 14, wherein the semiconductor body further comprises:
a superjunction structure comprising a plurality of columns of the second conductivity type positioned in the drift region and extending substantially perpendicularly to the first surface, and
a plurality of gate trenches, one of the gate trenches being arranged laterally between individual ones of the columns of the second conductivity type.
